# EUROPÄISCHE PATENTSCHRIFT

(11) **EP 3 963 121 B1**
(45) Veröffentlichungstag und Bekanntmachung des Hinweises auf die Patenterteilung: **10.05.2023**
(21) Anmeldenummer: 20714530.1
(22) Anmeldetag: 24.03.2020
(51) Int. Cl.: C23C 10/32, C23C 10/30, C23C 10/60, C23C 16/02, C23C 16/26, F02M 59/44, F02M 61/10

(54) **VERFAHREN ZUM BESCHICHTEN EINER MECHANISCH HOCHBELASTETEN OBERFLÄCHE EINES BAUTEILS SOWIE BESCHICHTETES BAUTEIL SELBST**
METHOD FOR COATING A MECHANICALLY HIGHLY LOADED SURFACE OF A COMPONENT, AND COATED COMPONENT ITSELF
PROCÉDÉ DE REVÊTEMENT D'UNE SURFACE D'UN COMPOSANT SOUMISE À FORTE CONTRAINTE MÉCANIQUE ET COMPOSANT LUI-MÊME REVÊTU

(30) Priorität: 03.05.2019 DE 102019206420
(43) Veröffentlichungstag der Anmeldung: 09.03.2022
(73) Patentinhaber: Robert Bosch GmbH, 70442 Stuttgart (DE)
(72) Erfinder: MANDL, Bernhard, 4040 Linz (AT)
(86) Internationale Anmeldenummer: PCT/EP2020/058133
(87) Internationale Veröffentlichungsnummer: WO 2020/224859

(56) Entgegenhaltungen:
- EP-A1- 3 216 893
- DE-A1-102012 214 284
- US-A1- 2018 363 128
- LI K Y ET AL: "Study of tribological performance of ECR-CVD diamond-like carbon coatings on steel substrates", WEAR, ELSEVIER SEQUOIA, LAUSANNE, CH, Bd. 258, Nr. 10, 1. Mai 2005 (2005-05-01), Seiten 1577-1588, XP027614413, ISSN: 0043-1648 [gefunden am 2005-05-01]

## Beschreibung

Die vorliegende Erfindung betrifft ein Verfahren zum Beschichten einer mechanisch hochbelasteten Oberfläche eines aus einem gehärteten Stahl mit Stickstoff- und/oder Kohlenstoffanteil bestehenden Bauteils mit einer Haft- und/oder Funktionsschicht zur Oberflächenvergütung. Weiterhin betrifft die Erfindung auch ein durch dieses Verfahren beschichtetes Bauteil selbst, welches beispielsweise eine Hochdruckventil-Komponente, eine Kraftstoffpumpen-Komponente oder dergleichen sein kann.

Das Einsatzgebiet der Erfindung erstreckt sich vornehmlich auf tribologisch hochbelastete Bauteile, vorzugsweise der Kraftfahrzeugtechnik. Funktionsschichten zur Oberflächenvergütung dienen vornehmlich dem Verschleißschutz und stellen ein weit verbreitetes Mittel zur Steigerung der Dauerbelastbarkeit dar. Ist neben dem Verschleißschutz des beschichteten Bauteils auch ein Schutz des unbeschichteten Gegenkörpers erwünscht, so haben sich sogenannte Hartstoffschichten und die DLC-Beschichtung (Diamond Like Carbon) durchgesetzt. Hartstoffschichten können beispielsweise aus Metallnitriden oder Metallcarbiden bestehen. Insbesondere in der Automobiltechnik werden Bauteile, wie beispielsweise Hochdruck-Komponenten, unter Einhaltung von sehr geringen Maßtoleranzen lokal stark beansprucht. So werden beispielsweise Hochdruckventil-Komponenten oder Hochdruckpumpen-Komponenten in Kraftstoffeinspritzsystemen mit DLC-Schichten vor Verschleiß geschützt. In Common-Rail-Systemen für direkt einspritzende Dieselmotoren werden auch die Düsennadeln der Kraftstoffinjektoren am Dichtsitz und je nach Anwendung auch im Bereich der Nadelführung mit DLC-Schichten geschützt. Am Dichtsitz muss das Schichtsystem durch Überlagerung von Schwingbewegungen des Kraftstoffsystems intensive Mehrfachbelastungen ertragen, die verursacht werden durch hohe Flächenpressungen, ungünstige Geometrien, hohe Schaltzykluszahlen infolge Mehrfacheinspritzungen und ungünstige Umgebungsbedingungen durch Temperaturen vom Brennraum, aggressiven Abgasen sowie Kraftstoffeinflüssen.

### Stand der Technik

Aus der DE 10 2005 037 549 A1 geht eine Beschichtung für mechanisch hochbelastete Bauteile der hier interessierenden Art hervor, die aus einer ersten harten Verschleißschutzschicht als Funktionsschicht und einer darauf angeordneten flexiblen Anpassschicht besteht. Dabei ist die Anpassschicht weniger hart und insoweit flexibler als die darunterliegende Verschleißschutzschicht. Hierdurch reibt sich die flexible Anpassschicht im Betrieb schneller ab und ermöglicht ein gleichmäßigeres und früheres Tragen von Sitzgeometrien bei Ventilen und dergleichen. Insbesondere können Fertigungstoleranzen oder unterschiedliche Einlaufbedingungen hierdurch ausgeglichen werden und gleichzeitig ein hoher Verschleißschutz erreicht werden. Die Verschleißschutzschicht besteht aus DLC mit einer Dicke von bis zu 3 µm und einer Härte von bis zu 20 bis 70 GPa, wohingegen die flexible Anpassschicht aus DLC mit einer Dicke von bis zu 5 µm und einer demgegenüber geringeren Härte von bis zu 10 bis 30 GPa besteht.

Die DE 102 13 661 A1 offenbart ein Verfahren zur Herstellung einer Beschichtung auf einem metallischen Bauteil. Dabei wird das Bauteil mittels eines Inertgases in einem Plasma an der Oberfläche geätzt und dann nach einem plasmaunterstützten CVD-Verfahren (Chemical Vapour Deposition) beschichtet. Dem Inertgas wird zumindest teilweise ein sauerstoffhaltiges Gas zugegeben. Hierdurch wird eine besonders hohe Schichthaftung erzielt.

Die US 2018/361128 A1 offenbart ein Verfahren zum Beschichten einer mechanisch hoch belasteten Oberfläche eines aus Stahl bestehenden Bauteils mit einer Haft- und Funktionsschicht zur Oberflächenvergütung. Diese Haft- und Funktionsschicht weist von innen nach außen eine Ti-Schicht , eine gradierte TiC-Schicht, eine TiC-Schicht und eine PACVD-DLC-Schicht auf. Diese Ti-Schicht wirkt wie eine Diffusionsbarriereschicht zwischen dem Substrat und der weiteren Funktionsschichten.

Die Funktionsschicht eines Bauteils der hier interessierenden Art muss daher über eine zuverlässige Schichtanbindung der auf die Bauteiloberfläche aufgebrachten Beschichtung verfügen. Neben der eigentlichen Funktionsschicht zur angestrebten Oberflächenvergütung kann zu diesem Zweck eine zusätzliche Haftschicht direkt auf die Bauteiloberfläche aufgebracht werden, worauf dann wiederum die Funktionsschicht aufgebracht wird.

Besteht das zu beschichtende Bauteil aus einem gehärteten Stahl, welcher insoweit regelmäßig Stickstoff- und/oder Kohlenstoffanteile besitzt, so gilt es, ein Eindringen von Stickstoff und/oder Kohlenstoff aus dem gehärteten Stahl in die Haft- oder Funktionsschicht zu vermeiden, um im Bereich der Beschichtung eine unerwünschte Materialumwandlung in Metallnitride oder Metallcarbide zu unterbinden, was zu einer Erhöhung der Oberflächenspannung sowie zu einem Enthaftungseffekt der Beschichtung führen kann.

Es ist daher die Aufgabe der vorliegenden Erfindung, ein Verfahren zum Beschichten der Oberfläche eines gattungsgemäßen Bauteils zu schaffen, welches das Aufbringen einer dauerhaltbaren Haft- oder Funktionsschicht mit minimalem Fertigungsaufwand ermöglicht.

### Offenbarung der Erfindung

Die Aufgabe wird ausgehend von einem Verfahren gemäß dem Oberbegriff von Anspruch 1 in Verbindung mit dessen kennzeichnenden Merkmalen gelöst. Hinsichtlich der Spezifikation eines aus diesem Verfahren hergestellten Bauteils wird auf Anspruch 5 verwiesen. Der Anspruch 9 benennt ein Hochdruckventil und eine Hochdruckpumpe, das/die mit einem erfindungsgemäß beschichteten Bauteil ausgestattet ist. Die jeweils rückbezogenen abhängigen Ansprüche geben vorteilhafte Weiterbildungen der Erfindung hinsichtlich verfahrenstechnischer oder produkttechnischer Merkmale wieder.

Die Erfindung schließt die verfahrenstechnische Lehre ein, dass vor dem Aufbringen der Haft- oder Funktionsschicht zunächst ein metallisches Bindematerial in die Oberfläche des aus einem gehärteten Stahl mit Stickstoff- und/oder Kohlenstoffanteil bestehenden Bauteils eingebracht wird, um eine oberflächenkonform verlaufende graduierte Diffusionsbarrierezone mit zur Oberfläche hin ansteigendem Anteil an Metallnitrid und/oder Metallcarbid zu schaffen.

Mit anderen Worten wird hierdurch eine oberflächenkonforme Diffusionsbarrierezone erzeugt, um ein Eindringen von Stickstoff und/oder Kohlenstoff aus dem gehärteten Stahl in die Beschichtung, also die Haft- oder Funktionsschicht, zu erschweren oder zu verhindern. Ein oberflächenkonformer Verlauf bedeutet hierbei, dass diese Diffusionsbarrierezone keine Beschichtung der Oberfläche darstellt, sondern in die Oberfläche des Bauteils eindringt und somit der Oberflächentopografie des Bauteils folgt, diese also nicht beeinträchtigt. Hierdurch können bestehende Zerklüftungen der Oberfläche erhalten werden, damit die hierauf aufgetragene Haft- oder Funktionsschicht besser anhaftet. Die graduierte Diffusionsbarrierezone zeichnet sich weiterhin durch einen Konzentrationsgradienten entlang der Zonendicke aus, der durch den zur Oberfläche hin ansteigenden Anteil an Metallnitrid und/oder Metallcarbid entsteht, welcher sich durch den aus dem gehärteten Stahl herausdiffundierenden Stickstoff und/oder Kohlenstoff bildet. Hierdurch entsteht eine wirksame Diffusionsbarriere in Richtung Bauteiloberfläche, so dass weiterer Stickstoff und/oder Kohlenstoff nicht mehr in den Bereich der Haft- oder Funktionsschicht gelangen kann oder die Diffusion von Stickstoff oder Kohlenstoff in die Haft- oder Funktionsschicht durch die Diffusionsbarriere wesentlich reduziert wird.

Vorzugsweise wird das Einbringen des metallischen Bindematerials durch Implantieren oder Eindiffundieren desselben durchgeführt. Beim an sich bekannten Implantieren handelt es sich um ein externes Beschleunigen des Bindematerials durch ein elektromagnetisches Feld, so dass dieses in die Bauteiloberfläche eingeschossen wird. Beim ebenfalls an sich bekannten Eindiffundieren handelt es sich um ein thermisches Verfahren, mit dem das auf die Oberfläche aufgebrachte Bindematerial über eine hinreichende Zeit so hoch erhitzt wird, dass eine Einlagerung in den Oberflächenbereich des Bauteils erfolgt, welcher ebenfalls die gewünscht oberflächenkonform verlaufende graduierte Diffusionsbarrierezone bildet. Das Einbringen des metallischen Bindematerials wird im Falle eines Eindiffundierens vorzugsweise bei einer Prozesstemperatur von 200 bis 500°C durchgeführt. Mittels Implantieren oder Eindiffundieren des metallischen Bindematerials werden Schichtdicken mit einer vorzugsweise Eindringtiefe T von 200 nm, ganz vorzugsweise von bis zu 100 nm, erzielt. Dabei ist eine Eindringtiefe T von bis zu 100 nm hinreichend, um den gewünschten Barriereeffekt zu erzielen. Eine Eindringtiefe T von über 200 nm führt dabei zu keinen signifikanten Verbesserungen des Barriereeffekts.

Das metallische Bindematerial zur Herstellung der Diffusionsbarrierezone ist ausgewählt aus einer Bindemetallgruppe, umfassend Chrom, Mangan, Molybdän, Wolfram und dergleichen. Diese Metalle sind besonders dazu geeignet, den aus dem gehärteten Stahl herausdiffundierenden Stickstoff und/oder Kohlenstoff als Nitride bzw. Carbide zu binden, um hiermit die Diffusionsbarrierezone auszubilden.

Die danach aufzubringende Haft- oder Funktionsschicht kann aus verschiedenen Materialien bestehen. Vorzugsweise kann eine haftvermittelnde Haftschicht als Chrom- oder Titanschicht ausgebildet sein, welche mit einer Hartstoffschicht als Funktionsschicht zur Oberflächenvergütung zusammenwirkt. Die Hartstoffschicht ist vorzugsweise aus DLC oder CrN, TiN, AlₓCr_{y}Ti_{z}N ausgebildet. Dieser Schichtaufbau erzeugt die gewünscht hochbelastbaren Bauteiloberflächen.

Hiermit können insbesondere tribologisch hochbelastete Bauteile von Hochdruckventilen oder Hochdruckpumpen ausgestattet werden, beispielsweise deren Steuerventilkomponenten, Hubkolben bzw. Düsennadeln sowie deren Gegenbauteile.

Weitere die Erfindung verbessernde Maßnahmen werden nachstehend gemeinsam mit der Beschreibung eines bevorzugten Ausführungsbeispiels anhand der Figuren näher dargestellt. Es zeigt:
- Fig. 1: einen schematischen Längsschnitt einer Beschichtung der Oberfläche eines Bauteils mit Diffusionsbarrierezone, und
- Fig. 2: eine schematische Darstellung der Schrittfolge zur Erzielung einer Beschichtung gemäß Fig. 1.

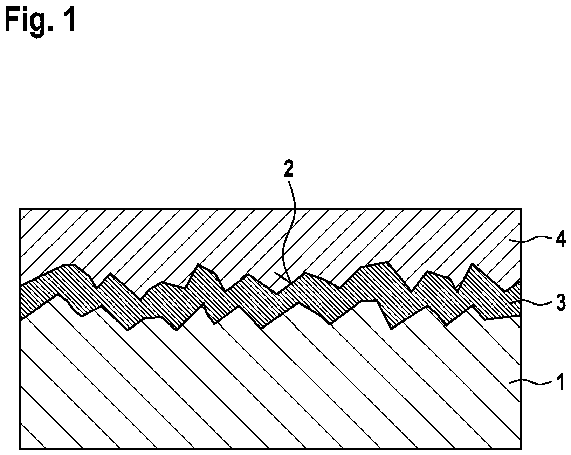

Gemäß Fig. 1 besteht ein im oberflächennahen Bereich hier ausschnittsweise dargestelltes Bauteil 1 aus einem gehärteten Stahl mit Stickstoff- und Kohlenstoffanteil. Die Oberfläche 2 des Bauteils 1 weist eine dem Metallgefüge entsprechende zerklüftete Oberflächentopologie auf, die sich hier im mikroskopischen Maßstab darstellt. Eine entsprechend oberflächenkonform verlaufende graduierte Diffusionsbarrierezone ist derart eingebracht, dass sich ein zur Oberfläche 2 hin ansteigender Anteil an Metallnitrid und Metallcarbid abzeichnet, welcher eine Barrierewirkung dafür entfaltet, dass weiterer Stickstoff und Kohlenstoff aus dem gehärteten Stahl nach außen entweichen kann.

Auf der so modifizierten Oberfläche 2 ist eine Haft- oder Funktionsschicht 4 mittels plasmaunterstütztem CVD-Verfahren aufgebracht. Die Haft- oder Funktionsschicht 4 ist in diesem Ausführungsbeispiel als eine Hartstoffschicht ausgebildet, welche aus DLC besteht.

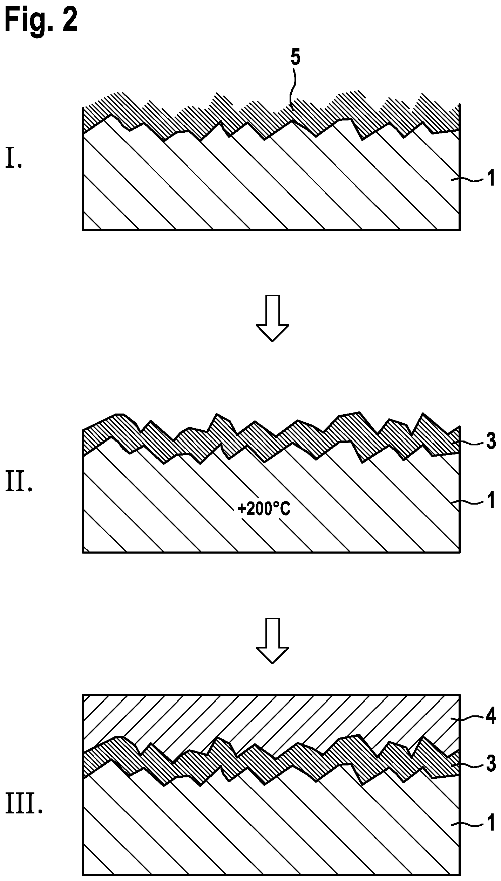

Gemäß Fig. 2 wird zum Beschichten der Oberfläche 2 eines Bauteils 1, welches aus einem nitrierten oder carbonierten Chrom-Nickel-Stahl als gehärtete Stahllegierung besteht, zunächst ein metallisches Bindematerial 5 aufgebracht. Das metallische Bindematerial 5 ist hier ein Chrom-Pulver. Durch Erhitzen des Bauteils 1 mit dem aufgebrachten metallischen Bindematerial 5 auf eine Temperatur von ca. 200°C dringt das metallische Bindematerial 5 über die Oberfläche 2 in das Bauteil 1 ein, so dass sich eine graduierte Diffusionsbarrierezone 3 im Bauteil 1 ausbildet, welches in Richtung Oberfläche 2 einen ansteigenden Anteil an Chromnitrid sowie Chromcarbid aufweist. Dabei verläuft die so geschaffene graduierte Diffusionsbarrierezone 3 oberflächenkonform.

Anschließend wird die Haft- oder Funktionsschicht 4 auf die Oberfläche 2 des Bauteils 1 aufgebracht, welche der finalen Oberflächenvergütung zur Steigerung der mechanischen Belastbarkeit des Bauteils 1 dient.

Die Erfindung ist nicht beschränkt auf das vorstehend beschriebene bevorzugte Ausführungsbeispiel. Es sind vielmehr auch Abwandlungen hiervon denkbar, welche vom Schutzbereich der nachfolgenden Ansprüche mit umfasst sind. So ist es beispielsweise auch möglich, statt einer finalen Funktionsschicht zunächst eine zwischengeschaltete Haftschicht auf die Bauteiloberfläche aufzutragen, welche anschließend mit der Funktionsschicht versehen ist. Dieser Schichtaufbau führt - je nach Materialkombination - zu einer noch einer verbesserten Schichthaftung.

## Patentansprüche

1. Verfahren zum Beschichten einer mechanisch hoch belasteten Oberfläche (2) eines aus einem gehärteten Stahl mit Stickstoff- und/oder Kohlenstoffanteil bestehenden Bauteils (1) mit einer Haft- oder Funktionsschicht (4) zur Oberflächenvergütung,
**dadurch gekennzeichnet, dass** vor Aufbringen der Haft- oder Funktionsschicht (4) ein metallisches Bindematerial (5) in die Oberfläche (2) eingebracht wird, um eine oberflächenkonform verlaufende graduierte Diffusionsbarrierezone (3) mit zur Oberfläche (2) hin ansteigendem Anteil an Metallnitrid und/oder Metallkarbid zu schaffen.

2. Verfahren nach Anspruch 1,
**dadurch gekennzeichnet, dass** das Einbringen des metallischen Bindematerials (5) durch Implantieren oder Eindiffundieren durchgeführt wird.

3. Verfahren nach Anspruch 2,
**dadurch gekennzeichnet, dass** das Einbringen des metallischen Bindematerials (5) im Falle eines Eindiffundierens bei einer Prozesstemperatur von 200 bis 500 °C durchgeführt wird.

4. Verfahren nach Anspruch 1,
**dadurch gekennzeichnet, dass** das Einbringen des metallischen Bindematerials (5) mit einer Eindringtiefe (T) von bis zu 200 Nanometern, vorzugsweise von bis zu 100 Nanometern, durchgeführt wird.

5. Bauteil, beschichtet nach einem Verfahren gemäß einem der vorstehenden Ansprüche,
**dadurch gekennzeichnet, dass** das metallische Bindematerial (5) zur Herstellung der Diffusionsbarrierezone (3) ausgewählt ist aus einer Bindemetallgruppe, umfassend Chrom, Mangan, Molybdän, Wolfram.

6. Bauteil nach Anspruch 5,
**dadurch gekennzeichnet, dass** die Haft- oder Funktionsschicht (4) als eine Chrom- oder Titanlegierungsschicht zur Haftvermittlung beziehungsweise eine Hartstoffschicht zur Oberflächenvergütung ausgebildet ist.

7. Bauteil nach Anspruch 5,
**dadurch gekennzeichnet, dass** die Haft- oder Funktionsschicht (4) als eine aus Diamond-Like-Carbon (DLC) bestehende Hartstoffschicht ausgebildet ist.

8. Bauteil nach Anspruch 5,
**dadurch gekennzeichnet, dass** das Bauteil (1) aus einem nitrierten oder karbonitrierten Chrom-Nickel-Stahl als gehärtete Stahllegierung besteht.

9. Hochdruckventil oder Hochdruckpumpe eines Kraftstoffeinspritzsystems eines Kraftfahrzeuges, das mit einem Bauteil (1) nach einem der Ansprüche 5 bis 8 ausgestattet ist.

10. Hochdruckventil nach Anspruch 9, wobei das Bauteil (1) als eine Düsennadel oder eine Steuerventilkomponente eines Kraftstoffinjektors ausgeführt ist.

## Claims

1. Process for coating a mechanically highly stressed surface (2) of a component (1) consisting of a hardened steel having a proportion of nitrogen and/or carbon with a bonding layer or functional layer (4) for surface upgrading, **characterized in that** a metallic binder material (5) is introduced into the surface (2) in order to create a graduated diffusion barrier zone (3) which conforms to the surface and has a proportion of metal nitride and/or metal carbide which increases in the direction of the surface (2) before application of the bonding layer or functional layer (4).

2. Process according to Claim 1, **characterized in that** the introduction of the metallic binder material (5) is carried out by implantation or inward diffusion.

3. Process according to Claim 2, **characterized in that** the introduction of the metallic binder material (5) is in the case of inward diffusion carried out at a process temperature of from 200 to 500°C.

4. Process according to Claim 1, **characterized in that** the introduction of the metallic binder material (5) is carried out with a penetration depth (T) of up to 200 nanometers, preferably of up to 100 nanometers.

5. Component which has been coated by means of a process according to any of the preceding claims, **characterized in that** the metallic binder material (5) for producing the diffusion barrier zone (3) is selected from a binder metal group comprising chromium, manganese, molybdenum, tungsten.

6. Component according to Claim 5, **characterized in that** the bonding layer or functional layer (4) is configured as a chromium alloy or titanium alloy layer for promoting adhesion or a hard material layer for surface upgrading.

7. Component according to Claim 5, **characterized in that** the bonding layer or functional layer (4) is configured as a hard material layer consisting of diamond-like carbon (DLC).

8. Component according to Claim 5, **characterized in that** the component (1) consists of a nitrided or carburized chromium-nickel steel as hardened steel alloy.

9. High-pressure valve or high-pressure pump of a fuel injection system of a motor vehicle, which is equipped with a component (1) according to any of Claims 5 to 8.

10. High-pressure valve according to Claim 9, wherein the component (1) is configured as a nozzle needle or a control valve component of a fuel injector.

## Revendications

1. Procédé pour le revêtement d'une surface fortement sollicitée mécaniquement (2) d'un élément de construction (1) constitué d'un acier durci contenant de l'azote et/ou du carbone, comportant une couche adhésive ou fonctionnelle (4) pour l'amélioration de la surface,
**caractérisé en ce que**, avant l'application de la couche adhésive ou fonctionnelle (4), un matériau de liaison métallique (5) est introduit dans la surface (2) pour créer une zone de barrière de diffusion graduée (3) s'étendant de manière conforme à la surface, comportant une proportion de nitrure métallique et/ou de carbure métallique augmentant en direction de la surface (2).

2. Procédé selon la revendication 1, **caractérisé en ce que** l'introduction du matériau de liaison métallique (5) est réalisée par implantation ou diffusion.

3. Procédé selon la revendication 2, **caractérisé en ce que** l'introduction du matériau de liaison métallique (5), dans le cas d'une diffusion, est effectuée à une température de processus de 200 à 500 °C.

4. Procédé selon la revendication 1, **caractérisé en ce que** l'introduction du matériau de liaison métallique (5) est effectuée avec une profondeur de pénétration (T) allant jusqu'à 200 nanomètres, de préférence jusqu'à 100 nanomètres.

5. Élément de construction revêtu par un procédé selon l'une quelconque des revendications précédentes, **caractérisé en ce que** le matériau de liaison métallique (5) pour la fabrication de la zone de barrière de diffusion (3) est choisi parmi un groupe de métaux de liaison comprenant le chrome, le manganèse, le molybdène, le tungstène.

6. Élément de construction selon la revendication 5, **caractérisé en ce que** la couche adhésive ou fonctionnelle (4) est réalisée sous la forme d'une couche d'alliage de chrome ou de titane pour la promotion de l'adhérence ou d'une couche de matériau dur pour l'amélioration de la surface.

7. Élément de construction selon la revendication 5, **caractérisé en ce que** la couche adhésive ou fonctionnelle (4) est réalisée sous la forme d'une couche de matériau dur constituée de Diamond-Like-Carbon (DLC).

8. Élément de construction selon la revendication 5, **caractérisé en ce que** l'élément de construction (1) est constitué d'un acier au chrome-nickel nitruré ou carbonitruré en tant qu'alliage d'acier durci.

9. Soupape haute pression ou pompe haute pression d'un système d'injection de carburant d'un véhicule automobile, qui est équipée d'un élément de construction (1) selon l'une quelconque des revendications 5 à 8.

10. Soupape haute pression selon la revendication 9, dans laquelle l'élément de construction (1) est réalisé sous la forme d'une aiguille de buse ou d'un composant de soupape de commande d'un injecteur de carburant.
